# DEMANDE DE BREVET EUROPEEN

(11) **EP 0 996 153 A1**
(43) Date de publication de la demande: **26.04.2000**
(21) Numéro de dépôt: 99410132.7
(22) Date de dépôt: 13.10.1999
(51) Int. Cl.: H01L 21/8242

(54) **Cellule memoire**

(30) Priorité: 14.10.1998 FR 9813035
(71) Demandeur: STMicroelectronics S.A., 94250 Gentilly (FR); FRANCE TELECOM, 75015 Paris (FR)
(72) Inventeur: Ciavatti, Jérome, 38400 Saint Martin d'Heres (FR); Boccaccio, Christian, 38000 Grenoble (FR)
(74) Mandataire: de Beaumont, Michel

(57) **Abrégé**

L'invention concerne un procédé de fabrication d'un condensateur d'une cellule mémoire volatile dans un circuit intégré, et de formation de contacts, comprenant les étapes suivantes :
a) déposer sur un substrat semiconducteur (1) une première couche isolante (13-1 ) d'une première épaisseur (D1) ;
b) former une structure de condensateur dont une première électrode (14) est en contact avec une première région (2-1) du substrat ;
c) déposer une deuxième couche isolante (13-2) d'une seconde épaisseur (E1) ; et
d) former un contact avec une deuxième région (2-2) du substrat et un contact avec une seconde électrode (16).

## Description

La présente invention concerne de façon générale la fabrication de cellules mémoire et, plus particulièrement, un procédé de fabrication de cellules mémoire dynamique à accès aléatoire (DRAM).

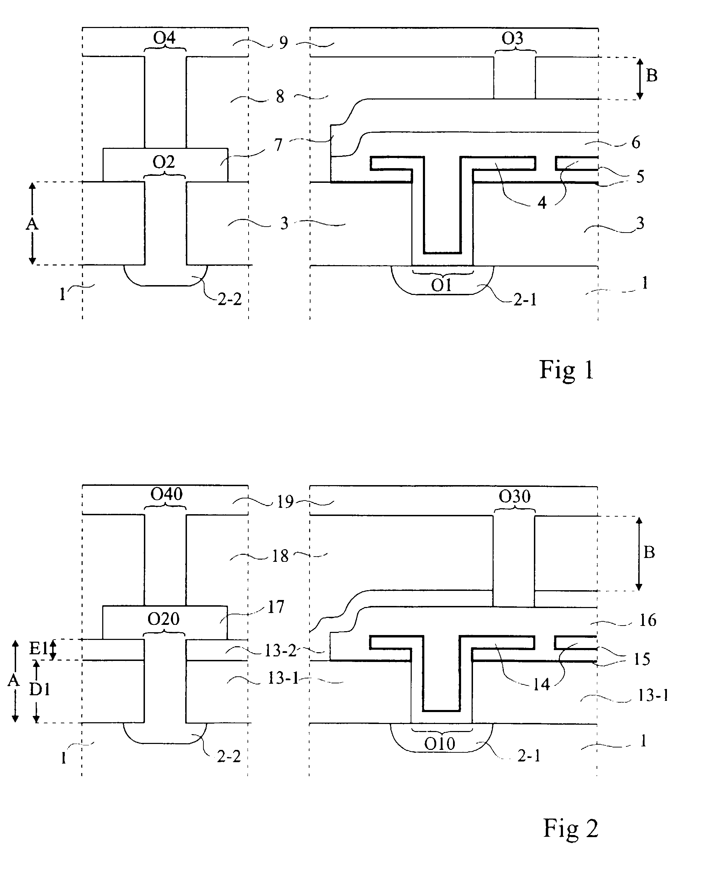

La figure 1 illustre schématiquement, vue en coupe, une partie d'une structure d'une cellule mémoire DRAM formée dans un circuit intégré selon un procédé de fabrication classique, décrit par exemple dans la demande de brevet français N° 96/10233 de A. Kalnitsky. Une telle cellule DRAM comprend un transistor MOS et un condensateur. On suppose ici que le transistor MOS (non représenté) a déjà été formé dans un substrat semiconducteur 1. Les parties apparentes du substrat 1, typiquement en silicium, sont généralement siliciurées, par exemple, en formant un siliciure de titane TiSi₂ (non représenté). À ce stade du procédé de fabrication, on cherche d'une part à former un condensateur dont une électrode est en contact avec une première région 2-1 formée dans le substrat 1 et, d'autre part, à établir un contact avec une région semiconductrice 2-2 également formée dans le substrat 1.

Pour ce faire, on forme une première ouverture O1 dans une première couche isolante 3, typiquement en oxyde de silicium, revêtue d'une couche sacrificielle (non représentée), de façon à exposer partiellement la région 2-1.

Aux étapes suivantes, on dépose et on grave une première couche conductrice 4, destinée à former une première électrode de condensateur, typiquement en silicium polycristallin. Selon la largeur de l'ouverture O1, et l'épaisseur de la couche 4, l'ouverture O1 peut être remplie complètement, formant un pied plein, ou peut présenter un évidement central, formant un pied évidé, comme l'illustre la figure 1.

On élimine ensuite la couche sacrificielle de sorte que la couche 4 forme un plateau en surélévation. On dépose alors de façon conforme un matériau diélectrique 5, destiné à constituer le diélectrique du condensateur, typiquement en oxyde de silicium (SiO₂), ou en nitrure de silicium (Si₃N₄), ou encore un multicouche d'oxyde de silicium, de nitrure de silicium et éventuellement une couche supplémentaire d'oxyde de silicium. On dépose et on grave ensuite une deuxième couche conductrice 6, typiquement en silicium polycristallin ou nitrure de titane.

On a formé ainsi un condensateur ayant une première électrode constituée du pied et du plateau constitués de la couche conductrice 4, un diélectrique constitué de la couche isolante 5 et une seconde électrode constituée de la couche conductrice 6. Généralement, la première région 2-1 avec laquelle le pied de la première électrode 4 est en contact, est la source du transistor MOS (non représenté), cette région de source ayant pu être préalablement siliciurée.

Aux étapes suivantes, on forme une deuxième ouverture O2 dans la couche isolante 3, de façon à exposer partiellement la région 2-2.

On dépose ensuite une troisième couche conductrice 7, de préférence métallique. Quand une telle couche 7, par exemple en tungstène, est incompatible avec le matériau, typiquement du silicium polycristallin, constituant la seconde électrode 6 on dépose préalablement sur la couche 6 une couche d'accrochage (non représentée), par exemple, un multicouche Ti/TiN. La couche conductrice 7 remplit l'ouverture O2 et recouvre la seconde électrode 6 du condensateur. La couche 7 est gravée selon un contour choisi. On notera en particulier que la partie de la couche 7 située au-dessus de l'ouverture O1 est disjointe de la partie de la couche 7 située au-dessus de l'ouverture O2.

On notera que les couches 6 et 7 sont électriquement confondues. En pratique, la couche 6 n'est donc nécessaire que si la couche isolante 5 et la couche métallique 7 sont incompatibles.

On dépose et on planarise alors une troisième couche isolante 8, typiquement en oxyde de silicium.

On forme ensuite simultanément dans la couche isolante 8 une troisième ouverture O3, de façon à exposer une première partie de la couche conductrice 7 au-dessus de la deuxième électrode 6, ainsi qu'une quatrième ouverture O4 de façon à exposer une seconde partie de la couche conductrice 7 s'étendant autour de l'ouverture O2.

Enfin, on dépose une quatrième couche conductrice 9, de préférence métallique, typiquement en aluminium, qui remplit les troisième et quatrième ouvertures O3 et O4.

Un tel procédé de fabrication d'une cellule mémoire DRAM dans un circuit intégré est complexe et contraignant.

Une première difficulté résulte du fait que la couche conductrice 7 est déposée simultanément sur la couche isolante 3 et sur la couche conductrice 6. Or les conditions du dépôt d'une telle couche conductrice, en particulier métallique, sur une surface isolante différent des conditions de dépôt d'une couche de même nature sur une surface conductrice. Un dépôt simultané accroît donc la complexité du procédé.

Dans un exemple de réalisation, les épaisseurs des différentes couches sont :
couche isolante 3 (épaisseur A) : comprise entre 500 et 1500 nm, par exemple de 1 µm ;
couche conductrice 4 : comprise entre 30 et 300 nm, par exemple de 80 nm ;
couche isolante 5 : comprise entre 2 et 20 nm, par exemple de 6 nm ;
couche conductrice 6 : comprise entre 10 et 1000 nm, par exemple de 250 nm ;
couche métallique 7 : comprise entre 200 et 800 nm, par exemple de 500 nm ;
couche isolante 8 (épaisseur B) : comprise entre 100 et 1460 nm, par exemple de l'ordre de 570 nm ; et
couche métallique 9 : comprise entre 100 et 1000 nm, par exemple de 500 nm.

Les contraintes d'épaisseur de la couche isolante 3, de la couche conductrice 7 et de la couche isolante 8 laissent une hauteur utile pour la réalisation des structures de condensateur très faible, comprise entre 40 et 1400 nm, par exemple de typiquement de 570 nm. Ces contraintes sont fixées par le procédé standard de formation du contact avec la région 2-1, et par la contrainte d'épaisseur minimale de séparation des couches conductrices 7 et 9. Cela constitue un inconvénient du procédé, du fait que la hauteur occupée par le condensateur est limitée.

En effet, si on formait une structure plus haute, l'épaisseur de la couche isolante 8, après planarisation, serait très faible voir nulle dans la région où doit être formée la troisième ouverture O3.

Un autre inconvénient de la présente invention réside en ce que la surface supérieure de la couche 7 présente une différence du niveau entre sa partie entourant la deuxième ouverture O2 et sa partie recouvrant la seconde électrode 6 du condensateur. D'une part, une telle différence de niveau complique la planarisation ultérieure de la couche 8. D'autre part, elle conduit à ce que les troisième et quatrième ouvertures O3 et O4 ont des profondeurs différentes, ce qui complique leur réalisation simultanée.

La présente invention vise à simplifier le procédé de fabrication de cellules mémoires DRAM.

La présente invention vise à proposer un nouveau procédé de fabrication qui permette d'éviter le dépôt d'une couche conductrice simultanément sur une couche isolante et sur une couche conductrice.

La présente invention vise également à proposer un tel procédé qui permette de former simultanément des troisième et quatrième ouvertures ayant sensiblement la même profondeur.

La présente invention vise également à proposer un tel procédé qui permette de former des structures de condensateur plus hautes, sans modifier l'épaisseur du dispositif.

Pour atteindre ces objets, la présente invention prévoit un procédé de fabrication d'un condensateur d'une cellule mémoire volatile dans un circuit intégré, et de formation de contacts, comprenant les étapes suivantes :
a) déposer sur un substrat semiconducteur une première couche isolante d'une première épaisseur ;
b) former une structure de condensateur dont une première électrode est en contact avec une première région du substrat ;
c) déposer une deuxième couche isolante d'une seconde épaisseur ; et
d) former un contact avec une deuxième région du substrat et un contact avec une seconde électrode.

Selon un mode de réalisation de la présente invention, la première épaisseur est sensiblement comprise entre 100 nm et 900 nm, la seconde épaisseur est sensiblement comprise entre 900 nm et 100 nm, leur somme étant sensiblement égale à 1 µm.

Selon un mode de réalisation de la présente invention, l'étape (b) de formation de la structure de condensateur se décompose en la séquence suivante :
b1) déposer une couche sacrificielle sur la première couche isolante ;
b2) former dans la couche sacrificielle et la première couche isolante une première ouverture, de façon à exposer partiellement la première région ;
b3) déposer et graver un premier matériau conducteur pour former la première électrode sous forme d'un plateau horizontal reposant sur un pied vertical formé dans la première ouverture ;
b4) éliminer la couche sacrificielle ;
b5) déposer de façon conforme un matériau diélectrique ; et
b6) déposer de façon conforme un deuxième matériau conducteur constituant une seconde électrode.

Selon un mode de réalisation de la présente invention, l'étape (b) de formation de la structure de condensateur se décompose en la séquence suivante :
b7) déposer une première couche sacrificielle sur la première couche isolante ;
b8) déposer une première couche conductrice ;
b9) déposer une seconde couche sacrificielle ;
b10) former une première ouverture dans l'empilement constitué des quatre couches déposées précédemment, de façon à exposer partiellement la première région ;
b11) déposer une deuxième couche conductrice de façon à recouvrir les parois et le fond de la première ouverture ;
b12) graver l'empilement constitué de la première couche sacrificielle et des première et deuxième couches conductrices pour former la première électrode ;
b13) éliminer les deux couches sacrificielles ;
b14) déposer de façon conforme un matériau diélectrique ; et
b15) déposer de façon conforme un troisième matériau conducteur constituant une seconde électrode.

Selon un mode de réalisation de la présente invention, la deuxième couche conductrice est de même nature que la première couche conductrice.

Selon un mode de réalisation de la présente invention, la première électrode et la deuxième électrode sont en silicium polycristallin.

Selon un mode de réalisation de la présente invention, l'étape (d) de formation des contacts se décompose en la séquence suivante :
d1) former dans les première et deuxième couches isolantes une ouverture de façon à exposer partiellement la deuxième région ;
d2) remplir l'ouverture, déposer et graver un premier matériau métallique ;
d3) déposer et planariser une troisième couche isolante ;
d4) former simultanément une troisième ouverture dans les deuxième et troisième couches isolantes et une quatrième ouverture dans la troisième couche isolante de façon à exposer respectivement une région de la seconde électrode et une région du premier matériau métallique ; et
d5) remplir les troisième et quatrième ouvertures et déposer un deuxième matériau métallique.

Selon un mode de réalisation de la présente invention, le premier matériau métallique est du tungstène.

Selon un mode de réalisation de la présente invention, le deuxième matériau métallique est de l'aluminium.

Selon un mode de réalisation de la présente invention, les première, deuxième et troisième couches isolantes sont en oxyde de silicium.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente partiellement, vue en coupe schématique, la structure d'une cellule mémoire DRAM réalisée selon un procédé de fabrication classique ;
la figure 2 représente partiellement, vue en coupe schématique, la structure d'une cellule mémoire DRAM fabriquée selon le procédé de la présente invention ; et
la figure 3 représente partiellement, vue en coupe schématique, une variante d'une cellule mémoire DRAM fabriquée selon le procédé de la présente invention.

Par souci de clarté, les mêmes éléments ont été désignés par les mêmes références aux différentes figures. De plus, comme cela est habituel dans la représentation des circuits intégrés, les différentes vues en coupe ne sont pas à l'échelle.

Le procédé de fabrication selon la présente invention sera exposé ci-après en relation avec la figure 2.

On veut former une cellule mémoire DRAM dans un circuit intégré. On suppose ici que le transistor MOS (non représenté) de commande d'une telle cellule a déjà été formé dans un substrat semiconducteur 1. On souhaite former d'une part un condensateur dont une électrode est en contact avec une première région 2-1 formée dans le substrat 1 et, d'autre part, un contact avec une région semiconductrice 2-2 également formée dans le substrat 1.

Selon l'invention, on dépose une première couche isolante 13-1, par exemple en oxyde de silicium, sur une épaisseur D1, comprise entre 100 et 1450 nm, choisie de la façon décrite ci-après.

Puis le procédé se poursuit par des étapes déjà décrites en relation avec la figure 1 : dépôt d'une couche sacrificielle (non représentée), formation d'une première ouverture O10, dépôt et gravure d'une première couche conductrice 14, élimination de la couche sacrificielle, dépôt d'un matériau diélectrique 15, dépôt et gravure d'une deuxième couche conductrice 16.

A l'étape suivante selon la présente invention, on dépose une deuxième couche isolante 13-2 d'une épaisseur E1, comprise entre 1400 et 50 nm, choisie de la façon décrite ci-après. De préférence, la couche isolante 13-2 est de même nature que la couche isolante 13-1.

On forme ensuite une deuxième ouverture O20 dans les première et deuxième couches isolantes 13-1 et 13-2 de façon à exposer partiellement la région 2-2. On dépose et on grave une troisième couche conductrice 17, de préférence métallique, par exemple du tungstène. Le procédé de fabrication se poursuit alors par des étapes déjà décrites en relation avec la figure 1 : dépôt et planarisation d'une troisième couche isolante 18, formation simultanée de troisième et quatrième ouvertures O30 et O40, et dépôt d'une quatrième couche conductrice 19, de préférence métallique, par exemple en aluminium.

En pratique, l'épaisseur A d'isolant nécessaire entre le substrat 1 et la couche 17 est donc répartie selon l'invention entre les épaisseurs modulables D1 et E1 des première et deuxième couches isolantes 13-1 et 13-2 choisies selon les critères suivants :
- leur somme est égale à l'épaisseur A, comprise entre 500 et 1500 nm ;
- la surface supérieure de la seconde électrode 16 est sensiblement coplanaire avec la surface supérieure de la couche 17, afin que les troisième et quatrième ouvertures O30 et O40 aient sensiblement la même profondeur ; et
- l'épaisseur E1 est minimisée afin de minimiser la différence de niveau de la surface supérieure de la couche isolante 18 entre les parties recouvrant la zone où est réalisée le contact avec la région 2-2 et la zone où est réalisée le contact avec la seconde électrode 26 du condensateur afin d'en simplifier la planarisation. Toutefois cette épaisseur doit avoir une valeur minimale de l'ordre de 50 nm, nécessaire à la protection de la seconde électrode 16 lors de la gravure de la couche 17.

Dans un exemple de réalisation, pour une épaisseur A de sensiblement 1 µm, les épaisseurs D1 et E1 sont respectivement comprises entre 100 nm et 900 nm, et 900 nm et 100 nm, leur somme étant sensiblement égale à 1 µm.

Un avantage de la présente invention est que la couche métallique 17 est déposée sur la seule couche isolante 13-2, au contraire de la couche correspondante d'une cellule classique (7, figure 1) qui devait être déposée sur une couche isolante (3) et sur une couche conductrice (6). Cela simplifie le procédé de dépôt.

Un autre avantage de la présente invention réside dans le fait que la différence de niveau entre les surfaces supérieures des couches 16 et 17 est considérablement réduite. Cela induit deux avantages. D'une part, la planarisation de la couche isolante 18 est simplifiée. D'autre part, les troisième et quatrième ouvertures O30 et O40 ont alors sensiblement la même profondeur. Par conséquent, formées simultanément, elles auront sensiblement la même largeur. Cela simplifie leur formation simultanée et leur remplissage ultérieur, par exemple par du tungstène.

Un avantage supplémentaire de la présente invention est de rendre modulable la hauteur utile possible pour réaliser une structure de condensateur.

En effet, le choix des épaisseurs des première et deuxième couches isolantes est effectué afin d'optimiser, entre la surface supérieure de la première couche isolante et la surface inférieure de la deuxième couche isolante, la hauteur disponible pour réaliser une structure de condensateur. Ainsi, on pourra former des condensateurs multiplans.

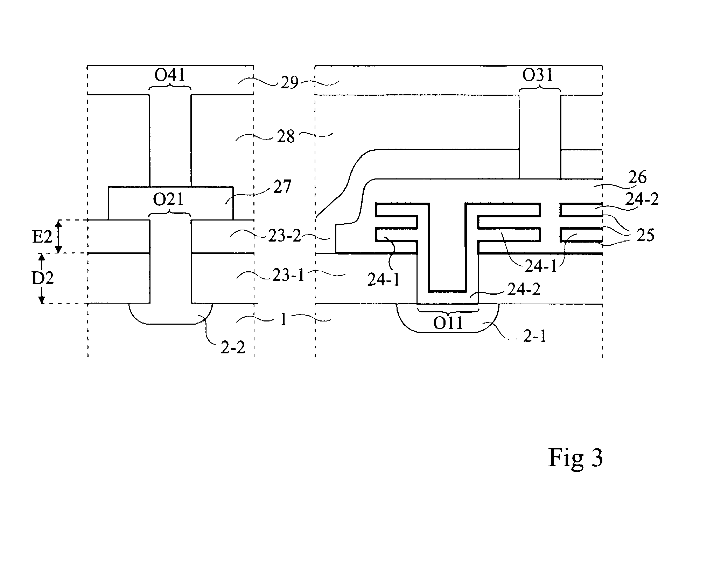

La figure 3 représente, vu en coupe schématique, un exemple de réalisation d'une cellule comportant des condensateurs biplans.

La fabrication de la cellule de la figure 3 commence par des étapes de dépôts successifs d'une première couche isolante 23-1, par exemple en oxyde de silicium, d'une première épaisseur D2 choisie de la façon décrite ci-après, d'une première couche sacrificielle (non représentée), d'une première couche conductrice 24-1, par exemple, en silicium polycristallin, et d'une seconde couche sacrificielle (non représentée).

On forme ensuite une première ouverture O11 dans l'empilement constitué des quatre couches déposées précédemment.

À l'étape suivante, on dépose une deuxième couche conductrice 24-2 de façon à recouvrir les parois de l'ouverture O11 et à former un plateau sur la deuxième couche sacrificielle. La couche 24-2 est, de préférence, de mêmes nature et épaisseur que la première couche conductrice 24-1 qu'elle contacte de la façon illustrée en figure 3.

On grave ensuite l'empilement de la deuxième couche sacrificielle et des couches conductrices 24-1 et 24-2, puis on élimine les deux couches sacrificielles de sorte que l'ensemble des couches 24-1 et 24-2 forme deux plateaux superposés en surélévation reposant sur un même pied. Cet ensemble constitue la première électrode d'un condensateur biplan.

Le procédé se poursuit alors selon l'invention par des étapes décrites précédemment en relation avec la figure 2 : dépôt conforme d'un matériau diélectrique 25, dépôt et gravure d'une couche conductrice 26, dépôt d'une deuxième couche isolante 23-2 d'une seconde épaisseur E2, formation dans les couches isolantes 23-1 et 23-2 d'une deuxième ouverture O21, dépôt et gravure d'une couche conductrice 27, dépôt d'une troisième couche isolante 28, formation dans les troisième et deuxième couches isolantes 28 et 23-2 d'une troisième ouverture O31 de façon à exposer une région de la seconde électrode 26 du condensateur, formation simultanée dans la couche isolante 28 d'une quatrième ouverture O41 de façon à exposer une région de la couche conductrice 27 et enfin remplissage des ouvertures O31 et O41 et dépôt d'une couche conductrice 29. De préférence, la couche isolante 23-2 est de même nature que la couche isolante 23-1, par exemple en oxyde de silicium.

Selon l'invention, les épaisseurs D2 et E2 des première et deuxième couches isolantes 23-1 et 23-2, par exemple comprises entre 100 et 900 nm, sont choisies de façon à :
- rendre leur somme égale à l'épaisseur A, comprise entre 500 et 1500 nm, par exemple de 1 µm ;
- respecter les contraintes d'isolation entre la couche 26 et le substrat 1 ;
- assurer la protection de la seconde électrode 26 lors de la gravure de la couche 27 ;
- dégager la hauteur nécessaire à la réalisation de la structure de condensateur biplan.

Les épaisseurs D2 et E2 sont également choisies de façon à minimiser la différence de niveau entre la couche métallique 27 et la seconde électrode 26, donc la différence de profondeur des troisième et quatrième ouvertures O31 et O41. On veillera à ce que cette différence de profondeur soit au plus de sensiblement 200 nm.

Un avantage de la présente invention est de permettre la formation de cellules mémoire DRAM comprenant un condensateur biplan dans un circuit ayant la même épaisseur que celui comportant des cellules mémoire classiques à condensateur à un seul plateau. Cela est obtenu en réduisant l'épaisseur D1 et augmentant l'épaisseur E1. La hauteur utile maximale selon la présente invention, comprise entre 40 et 3600 nm, par exemple de sensiblement 1,75 µm, au lieu de 570 nm selon un procédé classique est limitée uniquement par l'épaisseur minimale Dlmin de la couche 13-1 et l'épaisseur minimale Elmin après planarisation de la couche 13-2.

Un autre avantage de la présente invention est de réduire la différence de niveau entre la couche métallique 27 et la seconde électrode 26 ce qui facilite la planarisation de la couche isolante 28 et la formation simultanée des troisième et quatrième ouvertures O31 et O41.

Bien entendu, la présente invention est susceptible de diverses variantes et modifications qui apparaîtront à l'homme de l'art. En particulier, la position en hauteur de la structure de condensateur par rapport à la couche métallique (17 ; 27) de contact est modulable, en modifiant l'épaisseur (D1 ; D2) de la première couche isolante (13-1 ; 23-1). Par ailleurs, les première et deuxième régions (2-1 et 2-2) du substrat (1) peuvent être d'une quelconque forme et nature, voire le substrat lui-même. La surface de l'une et/ou l'autre de ces régions peut également avoir été préalablement siliciurée, par exemple en formant un siliciure de titane. De plus, bien que les matériaux des couches métalliques (17, 19 ; 27, 29) de remplissage des différentes ouvertures (O20, O30, O40 ; O21, O31, O41) autres que celle (O10 ; O11) liée à la formation de la première électrode du condensateur aient été choisis identiques au matériau métallique déposé au-dessus de et latéralement par rapport à ces ouvertures, on peut utiliser des matériaux de remplissage différents pour chacune des différentes ouvertures et/ou différents des matériaux des couches conductrices déposées au-dessus de ces ouvertures. Par exemple, les troisième et quatrième ouvertures (O30, O40 ; O31, O41) pourront être remplies de tungstène avant de déposer une couche (19 ; 29) d'aluminium.

## Revendications

1. Procédé de fabrication d'un condensateur d'une cellule mémoire volatile dans un circuit intégré, et de formation de contacts, comprenant les étapes suivantes :
a) déposer sur un substrat semiconducteur (1) une première couche isolante (13-1 ; 23-1) d'une première épaisseur (D1 ; D2) ;
b) former une structure de condensateur dont une première électrode (14 ; 24) est en contact avec une première région (2-1) du substrat ;
c) déposer une deuxième couche isolante (13-2 ; 23-2) d'une seconde épaisseur (E1 ; E2) ; et
d) former un contact avec une deuxième région (2-2) du substrat et un contact avec une seconde électrode (16 ; 26) ;
caractérisé en ce que l'étape (d) de formation des contacts se décompose en la séquence suivante :
d1) former dans les première (13-1 ; 23-1) et deuxième (13-2 ; 23-2) couches isolantes une ouverture (O20 ; O21) de façon à exposer partiellement la deuxième région (2-2) ;
d2) remplir l'ouverture, déposer et graver un premier matériau métallique (17 ; 27) ;
d3) déposer et planariser une troisième couche isolante (18 ; 28) ;
d4) former simultanément une troisième ouverture (O30 ; O31) dans les deuxième et troisième couches isolantes et une quatrième ouverture (O40 ; O41) dans la troisième couche isolante de façon à exposer respectivement une région de la seconde électrode et une région du premier matériau métallique ; et
d5) remplir les troisième et quatrième ouvertures et déposer un deuxième matériau métallique (19 ; 29).

2. Procédé selon la revendication 1, caractérisé en ce que la première épaisseur (D1 ; D2) est sensiblement comprise entre 100 nm et 900 nm, et en ce que la seconde épaisseur (E1 ; E2) est sensiblement comprise entre 900 nm et 100 nm, leur somme étant sensiblement égale à 1 µm.

3. Procédé selon la revendication 1 ou 2, caractérisé en ce que l'étape (b) de formation de la structure de condensateur se décompose en la séquence suivante :
b1) déposer une couche sacrificielle sur la première couche isolante (13-1) ;
b2) former dans la couche sacrificielle et la première couche isolante une première ouverture (O10), de façon à exposer partiellement la première région (2-1) ;
b3) déposer et graver un premier matériau conducteur (14) pour former la première électrode sous forme d'un plateau horizontal reposant sur un pied vertical formé dans la première ouverture ;
b4) éliminer la couche sacrificielle ;
b5) déposer de façon conforme un matériau diélectrique (15) ; et
b6) déposer de façon conforme un deuxième matériau conducteur (16) constituant une seconde électrode.

4. Procédé selon la revendication 1 ou 2, caractérisé en ce que l'étape (b) de formation de la structure de condensateur se décompose en la séquence suivante :
b7) déposer une première couche sacrificielle sur la première couche isolante (23-1) ;
b8) déposer une première couche conductrice (24-1) ;
b9) déposer une seconde couche sacrificielle ;
b10) former une première ouverture (O11) dans l'empilement constitué des quatre couches déposées précédemment, de façon à exposer partiellement la première région (2-1) ;
b11) déposer une deuxième couche conductrice (24-2) de façon à recouvrir les parois et le fond de la première ouverture ;
b12) graver l'empilement constitué de la première couche sacrificielle et des première et deuxième couches conductrices pour former la première électrode ;
b13) éliminer les deux couches sacrificielles ;
b14) déposer de façon conforme un matériau diélectrique (25) ; et
b15) déposer de façon conforme un troisième matériau conducteur (26) constituant une seconde électrode.

5. Procédé selon la revendication 4, caractérisé en ce que la deuxième couche conductrice (24-2) est de même nature que la première couche conductrice (24-1).

6. Procédé selon l'une quelconque des revendications 3 à 5, caractérisé en ce que la première électrode (14 ; 24-1) et la deuxième électrode (16 ; 26) sont en silicium polycristallin.

7. Procédé selon la revendication 6, caractérisé en ce que le premier matériau métallique (17 ; 27) est du tungstène.

8. Procédé selon la revendication 6 ou 7, caractérisé en ce que le deuxième matériau métallique (19 ; 29) est de l'aluminium.

9. Procédé selon l'une quelconque des revendications 6 à 8, caractérisé en ce que les première (13-1 ; 23-1), deuxième (13-2 ; 23-2) et troisième (18 ; 28) couches isolantes sont en oxyde de silicium (SiO₂).
